(19) Europäisches Patentamt / European Patent Office / Office européen des brevets

(11) **EP 1 076 413 B1**

(12) **EUROPEAN PATENT SPECIFICATION**

(45) Date of publication and mention
of the grant of the patent:
**07.01.2009 Bulletin 2009/02**

(51) Int Cl.:
***H03H 9/64*** *(2006.01)*     ***H03H 9/02*** *(2006.01)*

(21) Application number: **00402261.2**

(22) Date of filing: **10.08.2000**

(54) **Surface acoustic wave filter, duplexer and communications apparatus**

Akustisches Oberflächenwellenfilter, Duplexer und Kommunikationsgerät

Filtre à ondes acoustiques de surface, duplexeur et dispositif de communication

(84) Designated Contracting States:
**DE FR GB IT SE**

(30) Priority: **11.08.1999 JP 22756799**
**27.07.2000 JP 2000222907**

(43) Date of publication of application:
**14.02.2001 Bulletin 2001/07**

(73) Proprietor: **MURATA MANUFACTURING CO., LTD.**
**Nagaokakyo-shi, Kyoto 617-8555 (JP)**

(72) Inventor: **Taniguchi, Norio,**
**c/o(A170)Intellectual Prop. Dep.**
**Nagaokakyo-shi,**
**Kyoto-fu 617-8555 (JP)**

(74) Representative: **Thévenet, Jean-Bruno et al**
**Cabinet Beau de Loménie**
**158, rue de l'Université**
**75340 Paris Cédex 07 (FR)**

(56) References cited:
• **PATENT ABSTRACTS OF JAPAN vol. 1998, no. 14, 31 December 1998 (1998-12-31) -& JP 10 242799 A (KYOCERA CORP), 11 September 1998 (1998-09-11)**

**Description**

**BACKGROUND OF THE INVENTION**

1. Field of the Invention

The present invention relates to a surface acoustic wave filter for use in a communications apparatus that is used in high frequency bands, and more particularly to a ladder type surface acoustic wave filter.

2. Description of the Related Art

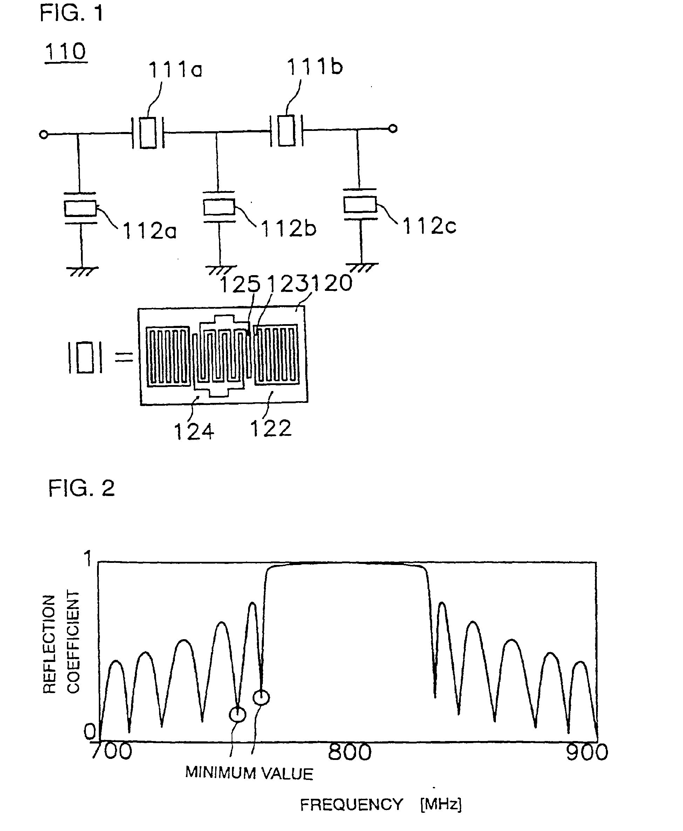

Generally, as a surface acoustic wave filter designed to achieve good characteristics such as low loss and wide band characteristics, a ladder type surface acoustic wave filter that has one-port resonators alternately arranged on series and parallel arms is known. FIG. 1 is a schematic view of a ladder type surface acoustic wave filter as described above. In a surface acoustic wave filter 110 shown in FIG. 1, two surface acoustic wave resonators 111a and 111b are connected to define a series arm, and three surface acoustic wave resonators 112a, 112b and 112c are connected to the series arm to define parallel arms, respectively. Each of these surface acoustic wave resonators 111a, 111b, 112a, 112b and 112c includes an interdigital transducer 124 having a plurality of electrode fingers 125, and a pair of reflectors 122 having a plurality of electrode fingers 123 which are provided on both sides of the interdigital transducer 124.

In the field of communications apparatus using the above-described surface acoustic wave filter, high-frequency requirements have been increasing, and development of new surface acoustic wave filters meeting the increased requirements is progressing. For example, Japanese Unexamined Patent Publication No. 9-167936 discloses a 38-to-46-degree Y-cut X-propagation $LiTaO_3$ substrate to meet the high-frequency requirements. Conventionally, as a substrate of the surface acoustic wave filter, a 36-degree Y-cut X-propagation $LiTaO_3$ substrate has conventionally been used because it produces a low propagation loss and has a large electromechanical coupling coefficient.

Although the propagation loss decreases where the thickness of an electrode film defining the interdigital transducers is negligibly small relative to the wavelength of a surface acoustic wave, the 36-degree Y-cut X-propagation $LiTaO_3$ has a problem in that the propagation loss increases where the thickness of an electrode film is increased. Particularly, as the wavelength of the surface acoustic wave decreases in the high-frequency band, the thickness of the electrode film relative to the wavelength becomes so large that the propagation loss increases. On the other hand, when the influence of bulk waves and the increase in electrode resistance are taken into account, reduction in thickness of the electrode film is not preferable because it causes degradation of the filter characteristics.

In view of the foregoing problems, Japanese Unexamined Patent Publication No. 9-167936 discloses that even in a case where the thickness of the electrode film is increased in consideration of the influence of bulk waves and the increase in the electrode resistance, the propagation loss can be reduced by use of the 38-to-46-degree Y-cut X-propagation $LiTaO_3$ substrate as a substrate of the surface acoustic wave filter.

Conventionally, as a modulation method for cellular phones, a TDMA (time division multiple method) has been used. Recently, however, a CDMA (code division multiple access method) is used to efficiently transmit an increasing amount of information. In ordinary cellular phone systems, the total-system frequency band is divided via channels into smaller bands. In this case, according to the TDMA method, the frequency width per channel is as small as several tens of kilohertz (kHz). However, according to the CDMA method, the frequency width is as large as 1 MHz or more.

Where very small ripples exist in the passband, the difference in the frequency width per channel according to the aforementioned modulation methods becomes apparent with the difference in influence of the ripples. Specifically, according to the TDMA method, when very small ripples exist in the passband, deviation in loss does not increase since the per-channel frequency width is relatively small. However, according to the CDMA method, the deviation in loss increases since the per-channel frequency width is relatively large. In the cellular phone system, a large amount of loss makes modulation difficult. With a large amount of deviation in loss that diffuses the frequency for information, a problem also arises in that the CDMA method itself makes modulation difficult. Therefore, with the CDMA method, very small ripples occurring in the passband become apparent as a problem while such ripples have not caused a problem in the TDMA method. In particular, the very small ripples are required to be reduced so as to have an amplitude of less than 0.7 dB.

Nonetheless, in the conventional ladder type surface acoustic wave filter, ripples having an amplitude of more than 0.7 dB have occurred in the passband because of interference of reflection caused in the interdigital transducers and interference of reflection caused in the reflectors in the series arm surface acoustic wave resonators.

Hereinbelow, a description will be given regarding reasons why the ripples are caused in the passband. The description will be provided referring to the reflector as an example, but the description can also be applied to the interdigital transducers.

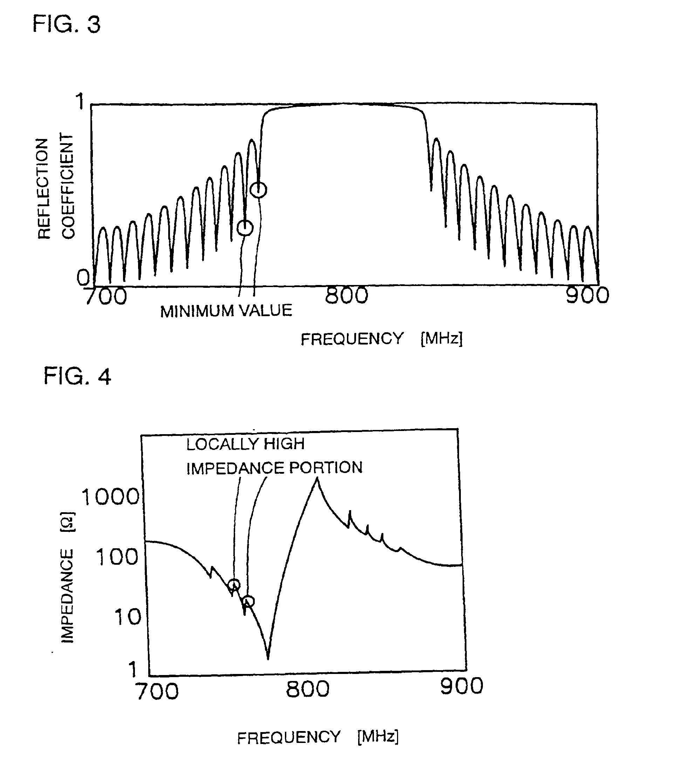

Each of FIGS. 2 and 3 shows frequency characteristics of the reflector. FIG. 2 shows the characteristic where the number of electrode fingers is 50, while FIG. 3 shows the characteristic where the number of electrode fingers is 100. In both of the figures, the center frequency is 800 MHz.

As shown in FIGS. 2 and 3, outside of the stopband, there are repeated minimum values of the reflection coefficient. With these minimum values, since excitation efficiency decreases, in view of the impedance characteristics of the surface acoustic wave resonator, locally-high-impedance portions occur, as shown in FIG. 4. A surface acoustic wave resonator having the characteristic in which the aforementioned locally-high-impedance portions occurs is series-connected as shown in FIG. 5, and transmission characteristics relative to the frequency are measured. As a result, it is known that very small ripples as shown in FIG. 6 occur. In FIG. 6, a graph indicated by B is an enlarged view of a graph indicated by A, and scale points thereof are indicated on the right side of the vertical axis (other characteristic views in this Specification are similarly presented). As shown in Fig. 6, when the ripples occur in the transmission characteristic of the series-connection configuration, ripples also occur in filter characteristics of a surface acoustic wave filter configured using the aforementioned surface acoustic wave resonator. That is, due to the influence of the minimum values of the reflection coefficient, ripples occur in filter characteristics of the surface acoustic wave filter.

Hereinbelow, a description will be given of frequencies having the aforementioned minimum values of the reflection coefficients.

Expression 1 shown below can be used to regulate frequencies f having the minimum values of the reflection coefficients by a center frequency $f_0$.

$$f/f_0 = (1 - K_{11}/k_0) \pm \{(K_{12}/k_0)^2 + (n_0/N)^2\}^{1/2}$$

In the above, $K_{11}$ and $K_{12}$ represent, respectively, a self-coupling coefficient (coefficient representing the coupling strength between surface acoustic waves proceeding in the same direction), which is uniquely determined according to factors such as substrate material and electrode-film thickness, and a mutual coupling coefficient (coefficient representing the coupling strength between surface acoustic waves proceeding in directions opposing each other); $k_0$ represents the number of waves in the center frequency; $n_0$ represents an integer larger than 0; and N represents the number of electrode fingers.

As shown in the expression that expresses the frequency having the minimum value, if the number N of the electrode fingers is infinite, $(n_0/N)^2 = 0$; however, if the number of the electrode fingers is finite, $(n_0/N)^2$ cannot be neglected, and a minimum value of the reflection coefficient exists for each value $n_0$ (integer larger than 0). That is, an innumerable number of the minimum values of reflection coefficients exists outside of the stopband. In addition, since $K_{11}$, $K_{12}$, and $K_0$ are determined to be constants in design, differences in frequency for the minimum values of the reflection coefficients are determined according to the number of the electrode fingers. In this case, the fewer the number N of the electrode fingers, the larger the difference in the frequency between locations where minima occur in the reflection coefficient. Clearly, from comparison between FIGS. 2 and 3, the differences in the frequency interval are increased in FIG. 2, which shows the case where the number of the electrode fingers is relatively small. Also, from comparing FIGS. 2 and 3, the minimum values of the reflection coefficients in FIG. 2 (showing the case where the number of the electrode fingers is relatively small) are even smaller than those in FIG. 3 (which shows the case where the number of the electrode finger is relatively large).

In the surface acoustic wave filter conventionally used, since the number of electrode fingers is not taken into consideration, the minimum value of the reflection coefficient arising corresponding to the number of electrode fingers in one of the series arm surface acoustic wave resonators occurs at the same frequency as the minimum value of the reflection coefficient arising corresponding to the number of electrode differs in another of the series arm surface acoustic wave resonators. Therefore, the effects of the two resonators reinforce each other, thereby producing larger ripples in the surface acoustic wave filter.

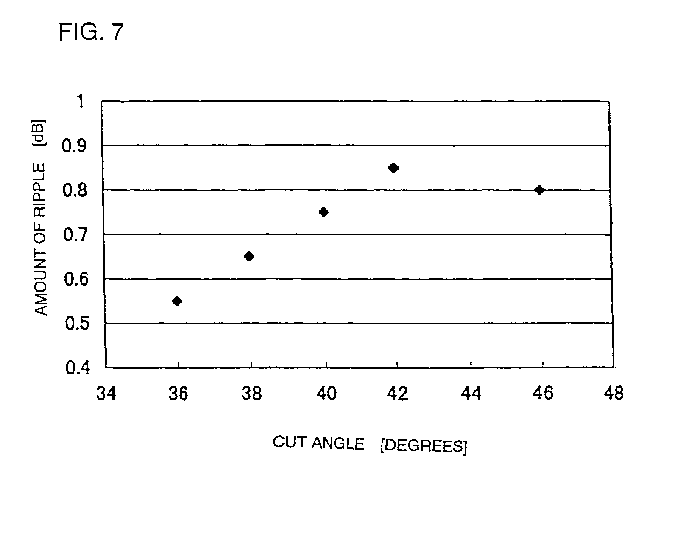

One reason that can be considered for occurrence of the enlarged ripples is that the propagation loss is reduced by use of a 38-to-46-degree Y-cut X-propagation $LiTaO_3$ substrate. Specifically, a no-load Q value (a parameter representing sharpness in resonance) increases, thereby increasing sharpness of the ripples occurring because of, for example, the aforementioned interdigital transducers. As shown in FIG.7, ripples increase when the cut angle is greater than 36 degrees.

Japanese patent application JP 10-242799 describes a technique for eliminating ripples in the passband of a SAW-resonator ladder-type filter by varying five parameters for each of the plurality of SAW resonators in the filter and deciding, empirically, which configuration produces the fewest ripples. The substrate used in the SAW-resonator ladder-type filter of JP 10-242799 is a conventional $LiTaO_3$ substrate having a cut angle of 36 degrees.

## SUMMARY OF THE INVENTION

To overcome the problems described above, preferred embodiments of the present invention provide a surface acoustic wave filter, a duplexer, and a communications apparatus, wherein the size of ripples in the transmission characteristic is reduced without losing the beneficial effects of a substrate used for reducing a propagation loss, and therefore, the ripples in the pass bands are smoothed.

According to a preferred embodiment of the present invention, a surface acoustic wave filter includes a Y-cut X-propagation LiTaO$_3$ substrate having a cut angle of 38 degrees to 46 degrees; at least first and second series arm surface acoustic wave resonators provided on the substrate and connected in series to define a series arm; and at least one parallel arm surface acoustic wave resonator provided on the substrate and connected to the series arm; wherein each of the first and second series arm surface acoustic wave resonators includes an interdigital transducer having a plurality of pairs of electrode fingers, and where the number of pairs of electrode fingers of the first series arm surface acoustic wave resonator is represented by N (N = a natural number), the corresponding number for the second series surface acoustic wave resonator (11b) differs from n × N (n = a natural number); and wherein the smallest number of pairs of electrode fingers in the aforementioned surface acoustic wave resonators on the series arm is 100 or less.

Specifically, with reference to one of the surface acoustic wave resonators that has either the smallest number of pairs of electrode fingers or the smallest number of electrode fingers, either the number of pairs of electrode fingers or the number of electrode fingers in at least one of the other surface acoustic wave resonators on the series arm is set so as not to be a positive integer multiple of said smallest number. As a result, ripples caused by the series arm surface acoustic wave resonator having either the smallest number of pairs of electrode fingers or the smallest number of electrode fingers (since either the number of pairs of electrode fingers or the number of electrode fingers is smallest, the size of ripples caused thereby is largest) are suppressed and minimized by the other series arm surface acoustic wave resonator in which either the number of pairs of electrode fingers or the number of electrode fingers is, not a positive integer multiple of said smallest number.

Other features, characteristics, elements and advantages of the present invention will become apparent from the following description of preferred embodiments thereof, given by way of example, with reference to the attached drawings.

## BRIEF DESCRIPTION OF THE DRAWINGS

FIG. 1 shows a configuration of an ordinary ladder type surface acoustic wave filter.

FIG. 2 shows the relationship between reflection coefficients and frequencies of a reflector in a case where the number of electrode fingers is 50.

FIG. 3 shows the relationship between reflection coefficients and frequencies of a reflector in a case where the number of electrode fingers is 100.

FIG. 4 shows the relationship between impedance and frequencies in a conventional surface acoustic wave filter.

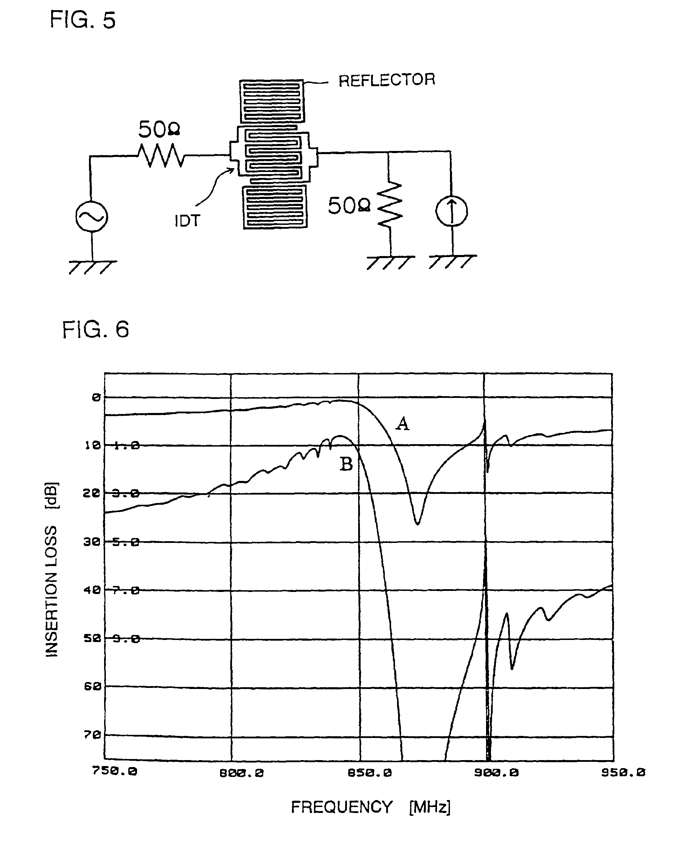

FIG. 5 is a connection view in a case where transmission characteristics are measured by series-connecting the surface acoustic wave resonator.

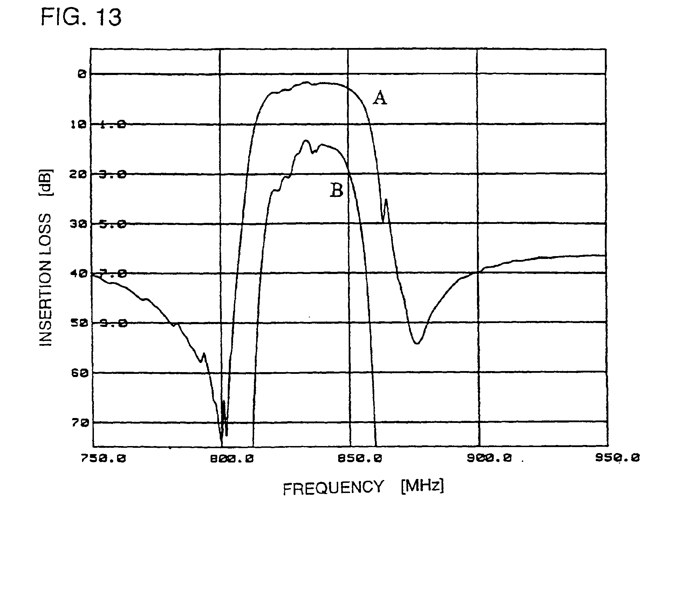

FIG. 6 shows a transmission-characteristic of a surface acoustic wave resonator connected in the manner shown in FIG. 13.

FIG. 7 is a graph showing a relationship between a cut angle and the amount of ripples.

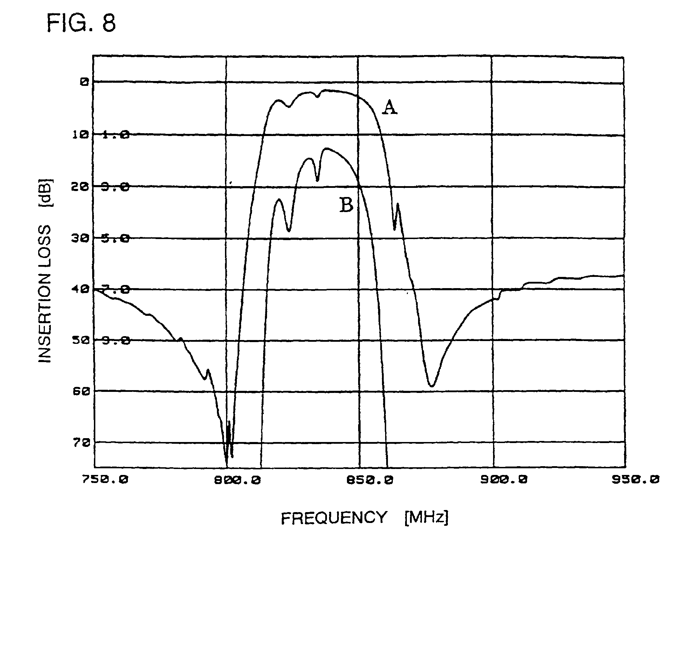

FIG. 8 shows a transmission characteristic of a surface acoustic wave filter in a case where the number of pairs of electrode fingers is 60.

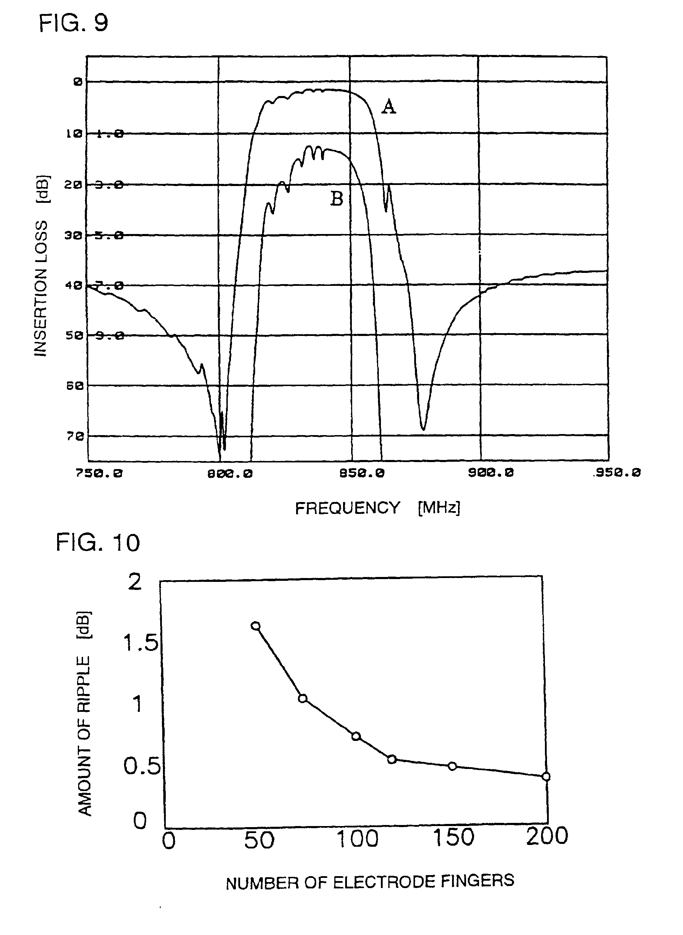

FIG. 9 shows a transmission characteristic of a surface acoustic wave filter in a case where the number of pairs of electrode fingers is 120.

FIG. 10 shows the ripple size in relation to the numbers of pairs of electrode fingers.

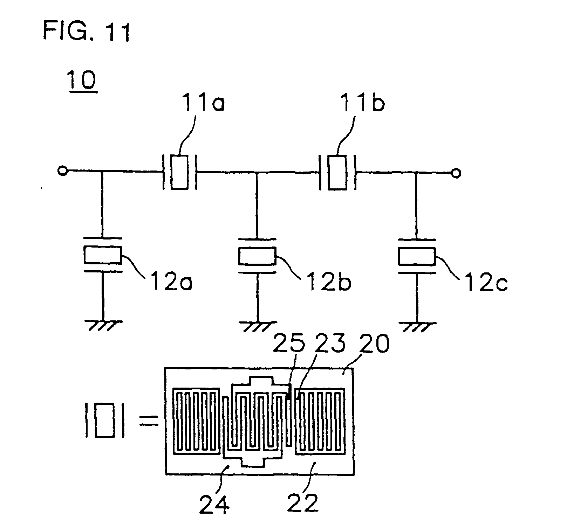

FIG. 11 shows a configuration of a surface acoustic wave filter according to a first preferred embodiment of the present invention.

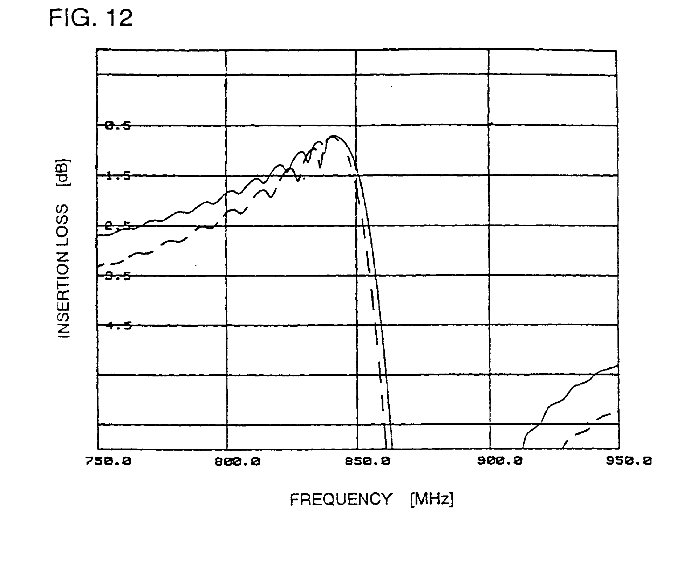

FIG. 12 shows transmission characteristics in a case where surface acoustic wave resonators that are used in the first preferred embodiment of the present invention are series-connected.

FIG. 13 shows a transmission characteristic of the surface acoustic wave filter according to the first preferred embodiment of the present invention.

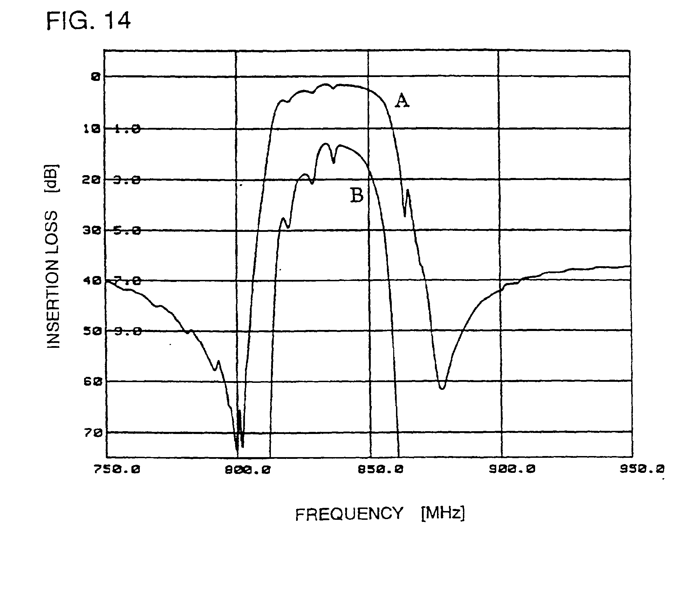

FIG. 14 shows a transmission characteristic of a comparison example of a surface acoustic wave filter.

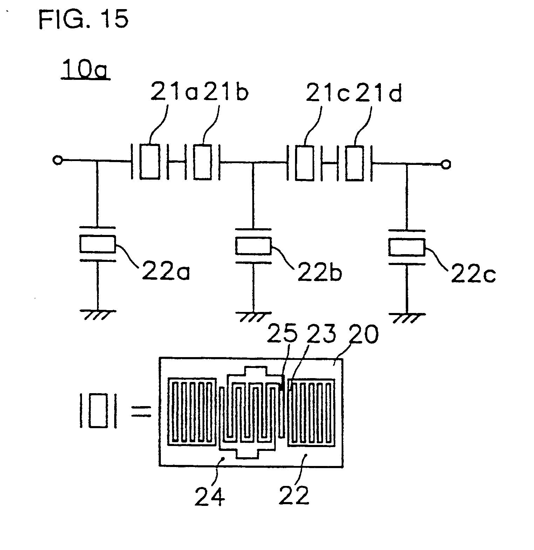

FIG. 15 shows a configuration of a surface acoustic wave filter according to a second preferred embodiment of the present invention.

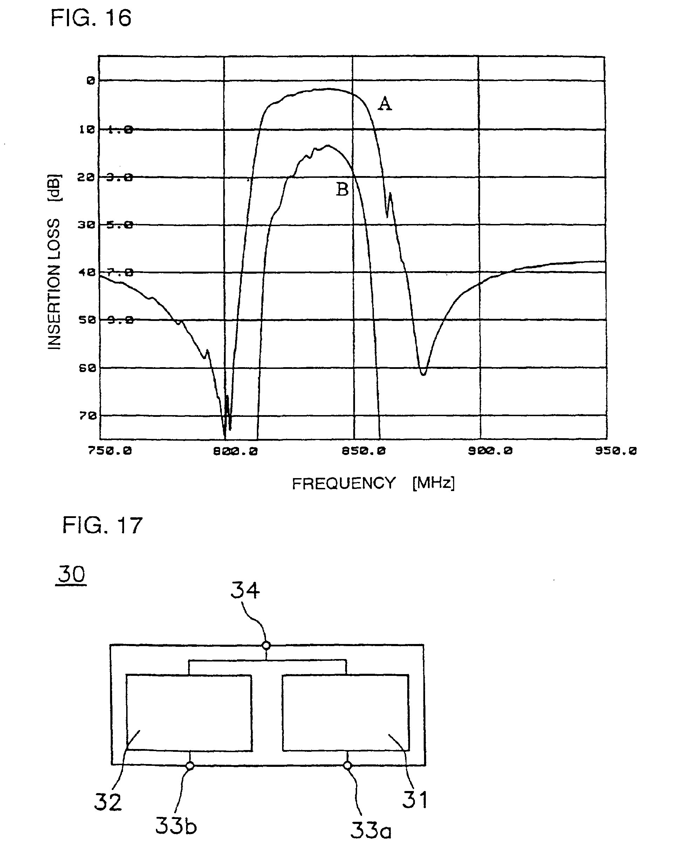

FIG. 16 shows a transmission characteristic of the surface acoustic wave filter according to the second preferred embodiment of the present invention.

FIG. 17 is a schematic view of a duplexer according to a preferred embodiment of the present invention.

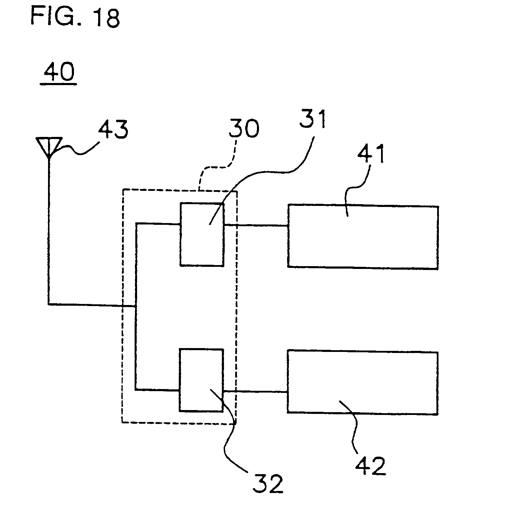

FIG. 18 is a schematic view of a communications apparatus of a preferred embodiment of the present invention.

## DETAILED DESCRIPTION OF PREFERRED EMBODIMENTS

Preferred embodiments of the present invention are described below with reference to the accompanying drawings.

The ripples occurring in the passbands of the surface acoustic wave filter are caused because the reflection coefficients of the interdigital transducers and the reflectors are decreased. The minimum value to which each of the reflection coefficients is decreased occurs periodically at an interval corresponding to the number of pairs of electrode fingers and the number of electrode fingers. Therefore, in preferred embodiments of the present invention, the number of pairs of electrode fingers and the number of electrode fingers in the series arm surface acoustic wave resonators are set so as to have a desired relationship that prevents the individual effects thereof from reinforcing each other. Specifically, where the number of pairs of electrode fingers in one of the series arm surface acoustic wave resonators that has the smallest number of electrode fingers is determined to be 40, the number of electrode fingers in at least one of the other series arm surface acoustic wave resonators is determined to be a value other than $n \times 40$ (n = natural number). This is because, similar to the case where the frequency corresponding to a minimum value of the reflection coefficient where N = 80 and $n_0 = 1$ corresponds with the frequency corresponding to a minimum value where N = 160 and $n_0 = 2$ according to Expression 1, generally, the frequency corresponding to the minimum value of reflection coefficient where N = 40 and $n_0 = 1$ agrees with the frequency corresponding to a minimum value where N = $n \times 40$ and $n_0 = n$. whereby effects of the two reinforce each other to cause enlarged ripples. Conversely, where the number of pairs of electrode fingers in at least one of the other series arm surface acoustic wave resonators is set to a value other than $n \times 40$, because frequencies at which the minimum values of the reflection coefficients occur deviate from each other, effects of the two cause ripples to suppress each other to cause reduced ripples. Accordingly, smoothness in the passband in the surface acoustic wave filter is greatly increased without any increase in propagation losses.

If three or more surface acoustic wave resonators are connected to the series arm surface acoustic wave filter, the number of pairs of electrode fingers and the number of electrode fingers in each of them are set so as not to be positive integer multiples of the number of pairs of electrode fingers and the number of electrode fingers in any of the other series arm surface acoustic wave resonators. Thereby, the minimum values of the reflection coefficients in all of the surface acoustic wave resonators on the series arm deviate from each other, whereby the individual effects thereof cause the ripples to suppress each other to allow the smoothness in the passband in the surface acoustic wave filter to be increased further.

In addition, preferred embodiments of the present invention are effective where the number of pairs of electrode fingers of the series arm surface acoustic wave resonator having the smallest number of pairs of electrode fingers is 100 or less.

Electrode capacitance is one of the parameters for determining electrical characteristics, such as the amount of attenuation and losses outside of the passband of the ladder type surface acoustic wave filter. The electrode capacitance is proportional to the multiplication product of the number of pairs of electrode fingers and the cross width thereof. Therefore, either the number of pairs of electrode fingers or the cross width is reduced to obtain a surface acoustic wave filter with small electrode capacitance for obtaining desired electrical characteristics. However, with a reduced cross width, for example, a cross width reduced to about 5 times or less relative to the wavelength, excitation with good efficiency cannot be obtained because it is influenced by diffraction loss and other factors. For this reason, the number of pairs of electrode fingers must be reduced to obtain desired electrical characteristics. However, generally, reduction in the number of pairs of electrode fingers causes enlarged ripples to occur.

FIGS. 8 and 9 show transmission characteristics of surface acoustic wave filters having different numbers of pairs of electrode fingers. Configurations of the surface acoustic wave filters are similar to that shown in FIG. 1. FIG. 8 shows the transmission characteristic where the number of pairs of electrode fingers in each of the surface acoustic wave resonators is 60. FIG. 9 shows the transmission characteristic where the number of pairs of electrode fingers in each of the surface acoustic wave resonators is 120. In addition, FIG. 10 is a graph showing the relationship between the ripple size and the number of pairs of electrode fingers at a cut angle of about 38 degrees. As will be apparent from comparison between FIG. 8 and FIG. 9. the smaller the number of pairs of electrode fingers, the larger the size of ripples existing in the passband. This is also apparent from the graph in FIG. 10.

As has already been described above, the smoothness in the passband is required to be increased for surface acoustic wave filters. Specifically, the smoothness in the passband is required to be about 0.7 dB or less. As can be seen from FIG. 10, according to the surface acoustic wave filter having the conventional configuration, in a case where the number of pairs of electrode fingers in the series arm surface acoustic wave resonator is 100 or less, the ripple size exceeds 0.7 dB. That is, it is very difficult to satisfy the present commercial needs with the conventional configuration.

Further, as described above, to obtain desired electrical characteristics, the number of pairs of electrode fingers must be reduced.

According to the surface acoustic wave filter of preferred embodiments of the present invention, effects of the series arm surface acoustic wave resonators cause ripples to suppress each other. Therefore, even where the number of pairs of electrode fingers is 100 or less, a surface acoustic wave filter having desired electrical characteristics and desired smoothness in the passband is obtained. This feature is especially advantageous in the case where the cut angle is approximately 38 degrees or more. Even where the number of pairs of electrode fingers is 100 or less, the ripples are successfully suppressed to produce a filter having ideal filter characteristics.

The surface acoustic wave filter of preferred embodiments of the present invention can be successfully applied to a duplexer. Typically, such a duplexer includes at least two of the filters described above, input/output-connections individually connected to the aforementioned filters, and an antenna-connection commonly connected to the aforementioned filters.

Furthermore, the surface acoustic wave filter of preferred embodiments of the present invention may be incorporated into a communications apparatus including the duplexer described above, a transmitting circuit connected to at least one of the input/output-connections of the aforementioned duplexer, a receiving circuit connected to at least one of the input/output-connections that differs from the aforementioned input/output-connection connected to the aforementioned transmitting circuit, and an antenna connected to the antenna-connection of the aforementioned duplexer.

According to the above, the duplexer and the communications apparatus have filter characteristics with the required increased smoothness in the passband.

A description will be provided of specific preferred embodiments of a surface acoustic wave filter according to the present invention.

FIG. 11 shows a configuration of a surface acoustic wave filter 10 according to a first preferred embodiment of the present invention. In the first preferred embodiment, two series arm surface acoustic wave resonators 11a and 11b, and three parallel arm surface acoustic wave resonator filters 12a, 12b and 12c each having an interdigital transducer 24 and reflectors 22, having respective electrode fingers 25 and 23, are made of aluminum electrodes on a 42-degree Y-cut X-propagation-LiTaO$_3$ substrate 20. In the series arm surface acoustic wave resonators 11a and 11b, the wavelength defined by an inter-electrode-finger pitch is about 4.66 $\mu$m, the cross width defined thereby is about 50 $\mu$m, and no reflector is provided. The number of pairs of electrode fingers is 68 in the IDT of the series arm surface acoustic wave resonator 11a and is 82 in the IDT of the series arm surface acoustic wave resonator 11b. In the parallel arm surface acoustic wave resonators 12a, 12b and 12c, the wavelength defined by an inter-electrode-finger pitch is about 4.86 $\mu$m and the cross width defined thereby in the parallel arm surface acoustic wave resonators 12a and 12c is about 120 $\mu$m, and is about 240 $\mu$m in the parallel arm surface acoustic wave resonator 12b, and the number of electrode fingers of each reflector is 60. The number of pairs of electrode fingers in the IDT of each of them is 80.

FIG. 12 shows the transmission characteristic of a configuration in which the surface acoustic wave resonators 11a and 11b used for the series amis are series-connected as shown in FIG. 11. In the characteristic view in FIG. 12, a graph where the surface acoustic wave resonator 11a is series-connected is indicated by a dotted line, and a graph where the surface acoustic wave resonator 11b is series-connected is shown by a solid line. It can he seen in FIG. 12 that frequency positions of ripples caused by the surface acoustic wave resonator 11a deviate from those caused by the surface acoustic wave resonator 11b.

FIG. 13 shows the transmission characteristic of the surface acoustic wave filter, and, as an example for comparison therewith, FIG. 14 shows the transmission characteristic of a configuration in which the conditions are the same, except that the number of pairs of electrode fingers in each of the series arm surface acoustic wave resonators 11a and 11b is changed to 75. As can be seen from FIGS. 13 and 14, ripples of 1 dB or more occur in the case shown in the comparison example (in which the numbers of pairs of electrode fingers in the two series arm surface acoustic wave resonators are the same). However, ripples are reduced to about 0.05 dB in the passband of the surface acoustic wave filter having the configuration according to preferred embodiments of the present invention. This indicates that, in the surface acoustic wave filter having the configuration according to preferred embodiments of the present invention, ripples caused by the series arm surface acoustic wave resonators are mutually suppressed.

FIG. 15 shows a configuration of a surface acoustic wave filter 10a according to a second preferred embodiment of the present invention. In the second preferred embodiment, four series arm surface acoustic wave resonators 21a, 21b, 21c and 21d, and three parallel arm surface acoustic wave resonator filters 22a, 22b, and 22c each having an IDT 24 and reflectors 22, having respective electrode fingers 25 and 23, are made of aluminum electrodes on a 42-degree Y-cut X-propagation-LiTaO$_3$ substrate 20. In the series arm surface acoustic wave resonators 21a, 21b, 21c and 21d, the wavelength defined by an inter-electrode-finger pitch is about 4.66 $\mu$m, the cross width defined thereby is about 95 $\mu$m, and no reflector is provided. The number of pairs of electrode fingers is 55 in the IDT of the series arm surface acoustic wave resonator 21a, is 95 in the IDT of the surface acoustic wave resonator 21b, is 80 in the IDT of the surface acoustic wave resonator 21c, and is 70 in the IDT of the series arm surface acoustic wave resonator 21d. In the parallel arm surface acoustic wave resonators 22a, 22b and 22c, the wavelength defined by an inter-electrode-finger pitch is

about 4.86 μm, the cross width defined thereby in the parallel arm surface acoustic wave resonators 22a and 22c is about 120 μm and is about 240 μm in the parallel arm surface acoustic wave resonator 22b, and the number of electrode fingers of each reflector is 60. The number of pairs of electrode fingers in the IDT of each parallel arm surface acoustic wave resonator is 80.

FIG. 16 shows the transmission characteristic of the surface acoustic wave filter having the above-described configuration. In the present preferred embodiment, the number of electrode fingers in each of the four series arm surface acoustic wave resonators is arranged not to be an integer multiple of that in any of the other series arm surface acoustic wave resonators. This establishes the relationship where ripples caused by each of the series arm surface acoustic wave resonators are suppressed by each other. Therefore, as can be seen from comparison between FIG. 13 (showing the passing-characteristics of the first preferred embodiment) and FIG. 16 (showing the transmission characteristic of the second preferred embodiment), smoothness in characteristics of the present embodiment is additionally increased.

Hereinbelow, referring to FIG. 17, a description will be provided of a duplexer according to another preferred embodiment of the present invention. FIG. 17 is a schematic view of a duplexer according to the present preferred embodiment.

As shown in FIG. 17, a duplexer 30 according to the preferred embodiment includes a transmitting filter 31 and a receiving filter 32, and input/output-connecting terminals 33a and 33b located, respectively, on the input side of the transmitting filter 31 and the output side of the receiving filter 32. The output side of the transmitting filter 31 and the input side of the receiving filter 32 are integrally connected to an antenna-connecting terminal 34. The transmitting filter 31 and the receiving filter 32 in the duplexer 30 are arranged and constructed in accordance with the above-described preferred embodiments. Only signals in a predetermined frequency band are allowed to pass in the transmitting filter 31, and signals in a frequency band different from that predetermined for the transmitting filter 31 are allowed to pass in the receiving filter 32.

In addition, referring to FIG. 18, a description will be given of a communications apparatus according to a preferred embodiment of the present invention. FIG. 18 is a schematic view of a communications apparatus of this preferred embodiment.

As shown in FIG. 18, a communications apparatus 40 includes the duplexer 30, a transmitting filter 41, a receiving filter 42, and an antenna 43. The duplexer 30 is described in the above preferred embodiment, in which the input/output-connecting terminal 33a connected to the transmitting filter 31 in FIG. 17 is connected to the transmitting filter 41, and the input/output-connecting terminal 33b connected to the receiving filter 32 in FIG. 17 is connected to the receiving filter 42. Also, the antenna-connecting terminal 34 is connected to the antenna 43.

While preferred embodiments of the invention have been disclosed, various modes of carrying out the principles disclosed herein are contemplated as being within the scope of the following claims. Therefore, it is understood that the scope of the invention is not to be limited except as otherwise set forth in the claims.

**Claims**

1. A surface acoustic wave filter (10) comprising:

   a Y-cut X-propagation LiTaO$_3$ substrate (20) having a cut angle of 38 degrees to 46 degrees;
   at least first (11a) and second (11b) series arm surface acoustic wave resonators provided on the substrate and connected in series to define a series arm; and
   at least one parallel arm surface acoustic wave resonator (12a-c) provided on the substrate and connected to the series arm;
   wherein each of the first and second series arm surface acoustic wave resonators (11a,11b) includes an interdigital transducer having a plurality of pairs of electrode fingers, and where the number of pairs of electrode fingers of the first series arm surface acoustic wave resonator (11a) is represented by N (N = a natural number), the corresponding number for the second series surface acoustic wave resonator (11b) differs from n × N (n = a natural number); and
   wherein the smallest number of pairs of electrode fingers in the aforementioned surface acoustic wave resonators on the series arm is 100 or less.

2. A surface acoustic wave filter (10a) according to Claim 1, wherein the surface acoustic wave filter includes a plurality of series arm surface acoustic wave resonators (21a-d) connected in series, each of the series arm surface acoustic wave resonators (21 a-d) has an interdigital transducer having a plurality of pairs of electrode fingers, and where the numbers of pairs of electrode fingers of the plurality of series arm surface acoustic wave resonators are respectively represented by N$_1$, N$_2$, ... N$_m$ (N$_1$, N$_2$, ... N$_m$ = natural numbers, and m is the number of series surface acoustic wave resonators), the number N$_k$ (k = 1 to m) thereof differs from n × N$_h$ (n = natural number; h=1 to m; but k and h differ from each other) for all k and h.

3. The surface acoustic wave filter according to Claim 1 or 2, wherein each of the series arm surface acoustic wave resonators (11a,11b) further includes a pair of reflectors, each reflector has a plurality of electrode fingers, and where the number of electrode fingers of each reflector of the first series arm surface acoustic wave resonator is represented by P (P = a natural number), the corresponding number for the reflectors in the second series arm surface acoustic wave resonator (11b) differs from $p \times P$ (p = a natural number).

4. A surface acoustic wave filter (10a) according to Claim 3, wherein the surface acoustic wave filter includes a plurality of series arm surface acoustic wave resonators (21a-d) connected in series, each of said series arm surface acoustic wave resonators (21a-d) has an interdigital transducer and a pair of reflectors, each reflector has a plurality of electrode fingers, and where the numbers of pairs of electrode fingers of each reflector of the plurality of series arm surface acoustic wave resonators are respectively represented by $P_1, P_2,...P_s$ ($P_1, P_2, ... P_s$ = natural numbers, and s is the number of series surface acoustic wave resonators), the number $P_q$ (q = 1 to s) thereof differs from $p \times P_i$ (p = natural number; i = 1 to s; but q and i differ from each other) for all q and i.

5. A duplexer (30) comprising:

   at least two filters (31,32), at least one of said at least two filters being a surface acoustic wave filter according to any one of claims 1 to 4;
   input/output-connection terminals (33a,33b) individually connected to the at least two filters (31-32); and
   an antenna-connection terminal (34) commonly connected to the at least two filters (31,32).

6. A communications apparatus (40) comprising:

   a duplexer (30) according to claim 5;
   a transmitting circuit (41) connected to at least one (33a) of the input/output-connection terminals of the duplexer;
   a receiving circuit (42) connected to at least one (33b) of the input/output-connection terminals that differs from the input/output-connection terminal (33a) connected to the transmitting circuit (41); and
   an antenna (43) connected to the antenna-connection terminal (34) of the duplexer.

**Patentansprüche**

1. Ein Oberflächenwellenfilter (10), das folgende Merkmale aufweist:

   ein Y-Schnitt-X-Ausbreitungs-LiTaO$_3$-Substrat (20), das einen Schnittwinkel von 38 Grad bis 46 Grad aufweist;
   zumindest einen ersten (11a) und einen zweiten (11b) Reihenarm-Oberflächenwellenresonator, die auf dem Substrat vorgesehen sind und in Reihe geschaltet sind, um einen Reihenarm zu definieren; und
   zumindest einen Parallelarm-Oberflächenwellenresonator (12a-c), der auf dem Substrat vorgesehen und mit dem Reihenarm verbunden ist;
   wobei sowohl der erste als auch der zweite Reihenarm-Oberflächenwellenresonator (11a, 11b) einen Interdigitalwandler umfasst, der eine Mehrzahl von Paaren von Elektrodenfingern aufweist, und wobei sich dort, wo die Anzahl von Paaren von Elektrodenfingern des ersten Reihenarm-Oberflächenwellenresonators (11a) durch N dargestellt wird (N = eine natürliche Zahl), die entsprechende Zahl für den zweiten Reihen-Oberflächenwellenresonator (11b) von $n \times N$ (n = eine natürliche Zahl) unterscheidet; und
   wobei die kleinste Anzahl von Paaren von Elektrodenfingern bei den zuvor erwähnten Oberflächenwellenresonatoren an dem Reihenarm 100 oder weniger beträgt.

2. Ein Oberflächenwellenfilter (10a) gemäß Anspruch 1, wobei das Oberflächenwellenfilter eine Mehrzahl von in Reihe geschalteten Reihenarm-Oberflächenwellenresonatoren (21a-d) umfasst, wobei jeder der Reihenarm-Oberflächenwellenresonatoren (21a-d) einen Interdigitalwandler aufweist, der eine Mehrzahl von Paaren von Elektrodenfingern aufweist, und wobei sich dort, wo die Anzahlen von Paaren von Elektrodenfingern der Mehrzahl von Reihenarm-Oberflächenwellenresonatoren jeweils durch $N_1, N_2, \cdots N_m$ ($N_1, N_2, ... N_m$ = natürliche Zahlen, und m ist die Anzahl von Reihen-Oberflächenwellenresonatoren) dargestellt werden, die Anzahl $N_k$ (k = 1 bis m) derselben für alle k und h von $n \times N_h$ (n = natürliche Zahl; h = 1 bis m; aber k und h unterscheiden sich voneinander) unterscheidet.

3. Das Oberflächenwellenfilter gemäß Anspruch 1 oder 2, bei dem jeder der Reihenarm-Oberflächenwellenresonatoren (11a, 11b) ferner ein Paar von Reflektoren umfasst, wobei jeder Reflektor eine Mehrzahl von Elektrodenfingern aufweist, und wobei sich dort, wo die Anzahl von Elektrodenfingern jedes Reflektors des ersten Reihenarm-Oberflächenwellenresonators durch P (P = eine natürliche Zahl) dargestellt wird, die entsprechende Anzahl für die Reflektoren bei dem zweiten Reihenarm-Oberflächenwellenresonator (11b) von p $\times$ P (p = eine natürliche Zahl) unterscheidet.

4. Ein Oberflächenwellenfilter (10a) gemäß Anspruch 3, wobei das Oberflächenwellenfilter eine Mehrzahl von in Reihe geschalteten Reihenarm-Oberflächenwellenresonatoren (21a-d) umfasst, wobei jeder der Reihenarm-Oberflächenwellenresonatoren (21a-d) einen Interdigitalwandler und ein Paar von Reflektoren aufweist, wobei jeder Reflektor eine Mehrzahl von Elektrodenfingern aufweist, und wobei sich dort, wo die Anzahlen von Paaren von Elektrodenfingern jedes Reflektors der Mehrzahl von Reihenarm-Oberflächenwellenresonatoren jeweils durch $P_1$, $P_2$, ... $P_s$ ($P_1$, $P_2$, $\cdots$ $P_s$ = natürliche Zahlen, und s ist die Anzahl von Reihen-Oberflächenwellenresonatoren) dargestellt werden, die Anzahl Pq (q = 1 bis s) derselben für alle q und i von p $\times$ $P_i$ (p = natürliche Zahl; i = 1 bis s; aber q und i unterscheiden sich voneinander) unterscheidet.

5. Ein Duplexer (30), der folgende Merkmale aufweist:

   zumindest zwei Filter (31, 32), wobei zumindest eines der zumindest zwei Filter ein Oberflächenwellenfilter gemäß einem der Ansprüche 1 bis 4 ist;
   Eingangs-/Ausgangsverbindungsanschlüsse (33a, 33b), die einzeln mit den zumindest zwei Filtern (31-32) verbunden sind; und
   einen Antennenverbindungsanschluss (34), der mit den zumindest zwei Filtern (31, 32) gemeinsam verbunden ist.

6. Eine Kommunikationsvorrichtung (40), die folgende Merkmale aufweist:

   einen Duplexer (30) gemäß Anspruch 5;
   eine Sendeschaltung (41), die mit zumindest einem (33a) der Eingangs-/Ausgangsverbindungsanschlüsse des Duplexers verbunden ist;
   eine Empfangsschaltung (42), die mit zumindest einem (33b) der Eingangs-/Ausgangsverbindungsanschlüsse verbunden ist, der sich von dem mit der Sendeschaltung (41) verbundenen Eingangs-/Ausgangsverbindungsanschluss (33a) unterscheidet; und
   eine Antenne (43), die mit dem Antennenverbindungsanschluss (34) des Duplexers verbunden ist.

## Revendications

1. Filtre à ondes acoustiques de surface (10) comprenant :

   un substrat en $LiTaO_3$ à coupe Y et propagation X (20) ayant un angle de coupe de 38 degrés à 46 degrés ;
   au moins un premier (11a) et un deuxième (11b) résonateurs à ondes acoustiques de surface de bras en série disposés sur le substrat et connectés en série pour définir un bras en série ; et
   au moins un résonateur à ondes acoustiques de surface de bras en parallèle (12a-c) disposé sur le substrat et connecté au bras en série ;
   dans lequel chacun des premier et deuxième résonateurs à ondes acoustiques de surface de bras en série (11a, 11b) comprend un transducteur interdigital ayant une pluralité de paires de doigts d'électrode, et où le nombre de paires de doigts d'électrode du premier résonateur à ondes acoustiques de surface de bras en série (11a) est représenté par N (N étant un nombre naturel), le nombre correspondant pour le deuxième résonateur à ondes acoustiques de surface en série (11b) différant de n x N (n étant un nombre naturel) ; et
   dans lequel le plus petit nombre de paires de doigts d'électrode dans les résonateurs à ondes acoustiques de surface susmentionnés du bras en série est de 100 ou moins.

2. Filtre à ondes acoustiques de surface (10a) selon la revendication 1, dans lequel le filtre à ondes acoustiques de surface comprend une pluralité de résonateurs à ondes acoustiques de surface de bras en série (21a-d) connectés en série, chacun des résonateurs à ondes acoustiques de surface de bras en série (21a-d) ayant un transducteur interdigital ayant une pluralité de paires de doigts d'électrode, et où les nombres de paires de doigts d'électrode de la pluralité de résonateurs à ondes acoustiques de surface de bras en série sont respectivement représentés par

$N_1$, $N_2$, ... $N_m$ ($N_1$, $N_2$, ... $N_m$ étant des nombres naturels et m étant le nombre de résonateurs à ondes acoustiques de surface en série), dont le nombre $N_k$ (k = 1 à m) diffère de n x $N_h$ (n étant un nombre naturel ; h = 1 à m ; mais k et h diffèrent l'un de l'autre) pour tous les k et h.

3. Filtre à ondes acoustiques de surface selon la revendication 1 ou 2, dans lequel chacun des résonateurs à ondes acoustiques de surface de bras en série (11a, 11b) comprend en outre une paire de réflecteurs, chaque réflecteur ayant une pluralité de doigts d'électrode, et où le nombre de doigts d'électrode de chaque réflecteur du premier résonateur à ondes acoustiques de surface de bras en série est représenté par P (P étant un nombre naturel), le nombre correspondant pour les réflecteurs dans le deuxième résonateur à ondes acoustiques de surface de bras en série (11b) différant de p x P (p étant un nombre naturel).

4. Filtre à ondes acoustiques de surface (10a) selon la revendication 3, lequel filtre à ondes acoustiques de surface comprenant une pluralité de résonateurs à ondes acoustiques de surface de bras en série (21a-d) connectés en série, chacun desdits résonateurs à ondes acoustiques de surface de bras en série (21a-d) ayant un transducteur interdigital et une paire de réflecteurs, chaque réflecteur ayant une pluralité de doigts d'électrode, et où les nombres de paires de doigts d'électrode de chaque réflecteur de la pluralité de résonateurs à ondes acoustiques de surface de bras en série sont respectivement représentés par $P_1$, $P_2$, ... $P_s$ ($P_1$, $P_2$, ... $P_s$ étant des nombres naturels et s étant le nombre de résonateurs à ondes acoustiques de surface en série), dont le nombre $P_q$ (q = 1 à s) diffère de p x $P_i$ (p étant un nombre naturel ; i = 1 à s ; mais q et i diffèrent l'un de l'autre) pour tous les q et i.

5. Duplexeur (30) comprenant :

au moins deux filtres (31, 32), au moins l'un desdits au moins deux filtres étant un filtre à ondes acoustiques de surface selon l'une quelconque des revendications 1 à 4 ;
des bornes de connexion d'entrée / sortie (33a, 33b) individuellement connectées aux au moins deux filtres (31-32) ; et
une borne de connexion à une antenne (34) connectée en commun aux au moins deux filtres (31, 32).

6. Dispositif de communications (40) comprenant :

un duplexeur (30) selon la revendication 5 ;
un circuit émetteur (41) connecté à au moins l'une (33a) des bornes de connexion d'entrée / sortie du duplexeur ;
un circuit récepteur (42) connecté à au moins l'une (33b) des bornes de connexion d'entrée / sortie qui diffère de la borne de connexion d'entrée/sortie (33a) connectée au circuit émetteur (41) ; et
une antenne (43) connectée à la borne de connexion à une antenne (34) du duplexeur.

FIG. 1

110

111a    111b

112a    112b    112c

125 123 120

|□| =

124    122

FIG. 2

REFLECTION COEFFICIENT

1

0

700    800    900

MINIMUM VALUE

FREQUENCY   [MHz]

11

FIG. 3

FIG. 4

# FIG. 5

# FIG. 6

FREQUENCY [MHz]

FIG. 7

CUT ANGLE [DEGREES]

FIG. 8

FIG. 11

<u>10</u>

## FIG. 12

INSERTION LOSS [dB]

0.5
1.5
2.5
3.5
4.5

750.0        800.0        850.0        900.0        950.0

FREQUENCY [MHz]

FIG. 13

FIG. 14

FIG. 15

<u>10a</u>

21a 21b          21c 21d

22a          22b          22c

25 23 20

|▢| =

24    22

FIG. 16

FIG. 17

30

FIG. 18

<u>40</u>

**EP 1 076 413 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 9167936 A
- JP 10242799 A